# EUROPEAN PATENT APPLICATION

(11) **EP 1 341 236 A2**
(43) Date of publication of application: **03.09.2003**
(21) Application number: 03075283.6
(22) Date of filing: 30.01.2003
(51) Int. Cl.: H01L 27/146

(54) **Programmable non-volatile memory for CMOS sensors**

(30) Priority: 11.02.2002 US 73733
(71) Applicant: EASTMAN KODAK COMPANY (a New Jersey corporation), Rochester, New York 14650 (US)
(72) Inventor: McDermott, Bruce C. c/o Eastman Kodak Company, Rochester, 14650-2201 (US); Janson Jr., Wilbert F. c/o Eastman Kodak Company, Rochester, 14650-2201 (US)
(74) Representative: Haile, Helen Cynthia

(57) **Abstract**

An image capture device for capturing an image includes an image sensor for receiving incident light; a microprocessor for assisting the image sensor in image capture; and non-volatile, programmable memory for storing predetermined variables that are loaded into the image sensor upon startup.

## Description

The present invention relates to memory for image sensors and, more particularly, to such image sensors having re-programmable or one-time programmable memory connected to and on the same substrate as the sensor for providing minimal time delays upon startup and efficient power consumption.

In prior art digital imaging devices, such as cameras, the imaging device contains an image sensor or imager for capturing the image. With a CMOS imager, current state of the art requires that all imager variables be established at camera startup. Typically, at power-up, the imager is reset to load the mask programmed default variables from read only memory (ROM) into the active variable registers. Then, a portion of these default variables is modified, typically, by a microprocessor that serially loads them into the imager. These microprocessor-loaded, static variables define the variables for the specific application of the imager.

Although the currently known and utilized apparatus and method for digital imaging startup is satisfactory, it includes drawbacks. All deviations from the default variables must be serially loaded into the CMOS imager. In addition, some imaging devices enable the microprocessor to read back the active registers and compare the loaded values with desired values. This creates time delays and consumes more power.

The present invention is directed to overcoming one or more of the problems set forth above. Briefly summarized, according to one aspect of the present invention, the invention resides in an image capture device for capturing an image comprising (a) a substrate (b) an image sensor on the substrate for receiving incident light; (c) non-volatile, programmable memory on the substrate for storing predetermined variables that are loaded into predetermined circuitry used to manage the image sensor upon startup. This programmable memory is integrated on the same substrate as the imager and the predetermined circuitry.

The above and other objects of the present invention will become more apparent when taken in conjunction with the following description and drawings wherein identical reference numerals have been used, where possible, to designate identical elements that are common to the figures.

The present invention includes the advantage of reducing camera power consumption and reducing the time to first image capture by not having to serially program the static variables.

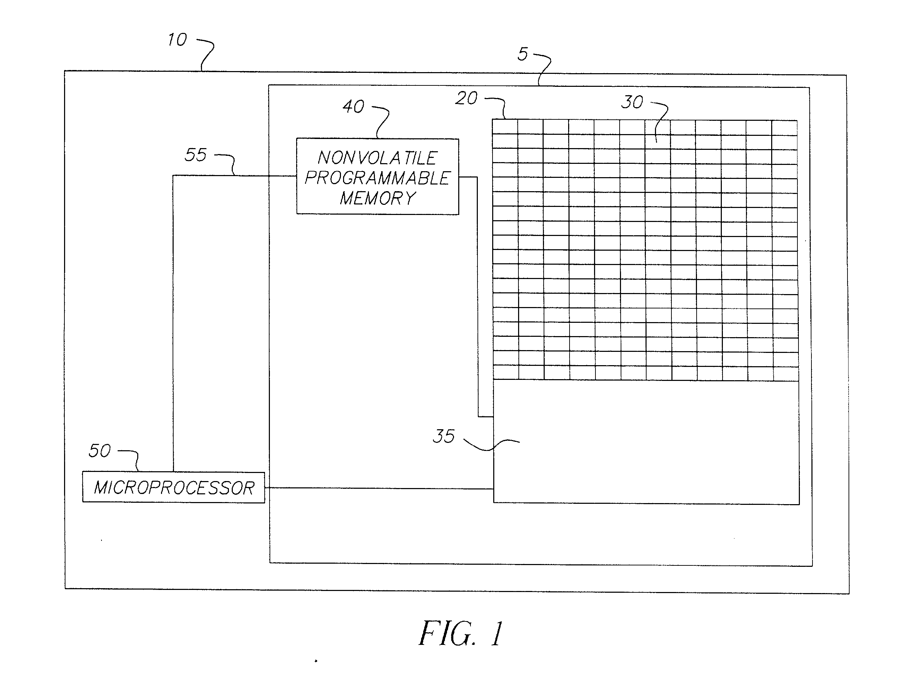

Fig. 1 is a schematic diagram of the one-time or re-programmable memory and imaging sensor of the present invention. The one-time or re-programmable memory is integrated with the imager on the same substrate.

Referring to Fig. 1, there is shown a substrate 5 containing below-described, electrical components integrally disposed on the substrate 5, as described in detail hereinbelow. A digital image capture device 10 of the present invention having an image sensor 20 for capturing incident light that is stored in electronic form. As is well known in the art, the sensor 20 includes a plurality of pixels 30 positioned in an array which individually capture a portion of the incident light, and an active register 35 for storing variable used during image capture. These variables establish the operating parameters for the imager. Programmable memory 40 is integrated on the substrate and electrically connected to the image sensor 20 for passing predetermined variables to active register 35 of the image sensor 20 upon startup. This programmable memory 40 is non-volatile which means it holds its programmed contents when power is removed. These variables are determined according to the specific use for the image capture device 10, and are input after determining the specific use for the image capture device 10. This input can be a one-time operation either at the imager manufacturer or at the device (camera) manufacturer. For example, a typical image capture device 10 may be either a digital camera, video camera, scanner, a high-speed image capture device and the like. As will be readily recognized by those skilled in the art, each type of image capture device 10 requires unique variable loaded into the registers 35 of the image capture device 10 based on the application. As used herein, programmable memory 40 means one-time programmable memory or re-programmable memory, such as either an electronic programmable read only memory (EPROM), FLASH programmable, non-volatile memory or programmable read only memory (PROM).

A microprocessor 50 is also electrically connected to the registers 50 for directing control of the digital image capture device such as modifying variables of the registers 35, serially loading these variables into registers 35 and the like. This microprocessor 50 can optionally be used to program the non-volatile memory 40 in lieu of using one-time programming at the factory. The programmable path 55 can be made bi-directional such that the microprocessor 50 can read back the contents of the non-volatile memory 40. This enables a compare function in the microprocessor 50 to verify the contents of the non-volatile memory 40.

Typical camera operation from startup for the present invention could be as follows. It is given that the one-time programmable memory or re-programmable memory contains the correct static variables for the application. For example, those serially loaded from the microprocessor 50 or previously factory programmed. At power up, the camera electronics assert and remove the reset. This initializes the active variable registers to the correct values for the application from the non-volatile programmable memory 40. The microprocessor 50 (or other device) modifies the active variable registers 35 (a much smaller quantity than in the prior art) to adjust to the immediate scene to be captured.

## Claims

1. An image capture device for capturing an image comprising:
(a) a substrate
(b) an image sensor on the substrate for receiving incident light; and
(c) non-volatile, programmable memory on the substrate for storing predetermined variables that are loaded into predetermined circuitry used to manage the image sensor upon startup.

2. The image capture device as in claim 1, wherein the programmable memory is PROM, FLASH or EPROM for providing non-volatile memory that keeps its contents when power is removed.

3. The image capture device as in claim 2, wherein the image sensor and integrally disposed programmable memory are components of a digital still camera.

4. The image capture device as in claim 1 further comprising a dedicated logic for loading the non-volatile memory prior to image capture.

5. A method for initiating startup of an image capture device, the method comprising the steps of:
(a) providing an image sensor for receiving incident light;
(b) providing a microprocessor for assisting the image sensor in image capture; and
(c) loading predetermined variables from non-volatile, programmable memory into the image sensor upon startup.

6. The method as in claim 5, wherein step (c) includes providing PROM, FLASH or EPROM as the non-volatile programmable memory.

7. The method as in claim 6 further comprising the step of enclosing the image sensor and integrally disposed programmable memory in a digital still camera.

8. The method as in claim 5 further comprising the step of providing dedicated logic for loading the non-volatile, programmable memory prior to image capture.
